# EUROPÄISCHE PATENTANMELDUNG

(11) **EP 3 979 478 A1**
(43) Veröffentlichungstag der Anmeldung: **06.04.2022**
(21) Anmeldenummer: 21211377.3
(22) Anmeldetag: 21.01.2019
(51) Int. Cl.: H02M 1/12, H01H 83/02, H02H 9/08

(54) **MASCHINEN MIT LEISTUNGSELEKTRONISCHEN ENERGIEWANDLERN UND ABLEITSTROMKOMPENSATION UND ANLAGE**

(30) Priorität: 31.01.2018 DE 102018102122
(62) Teilanmeldung aus: 19701336.0
(71) Anmelder: TDK Electronics AG, 81671 München (DE)
(72) Erfinder: KARINCA, Yasin, 89331 Burgau (DE)
(74) Vertreter: Epping - Hermann - Fischer

(57) **Zusammenfassung**

Er wird eine Vorrichtung, z. B. eine Maschine zur Produktion angegeben. Die Vorrichtung hat einen Laststromkreis, der einen Ableitstrom erzeugt. Ferner hat die Vorrichtung einen Ableitstromkompensator mit einer Einrichtung zum Erfassen des Ableitstroms sowie mit einer Einrichtung zum Erzeugen eines Kompensationsstroms, der dem Ableitstrom entgegen gerichtet ist und mit dem Ableitstrom überlagert wird derart, dass der Ableitstrom zumindest reduziert wird.

## Beschreibung

Die Erfindung betrifft eine Maschine oder Anlage gemäß dem Oberbegriff der unabhängigen Ansprüche.

Maschinen und Anlagen verwenden häufig Schaltnetzteile und elektronische Antriebe. Um die gesetzlichen Anforderungen an die elektromagnetische Verträglichkeit (EMV) zu erreichen, sind Filtermaßnahmen gegen elektrische Störungen nötig. Durch diese EMV-Filter entstehen Ableitströme, die Fehlerstromschutzschalter (RCD) - insbesondere, wenn diese zum Personenschutz dienen - auslösen können. Damit ist ein Betrieb an Steckdosen mit einem Fehlerstromschutzschalter für Personenschutz nicht möglich. Mit einem Fehlerstromschutzschalter mit höheren Auslöseschwellen sind aber die Maschinen und Gebäude nur gegen Brand geschützt. Die Maschinen und Anlagen werden daher oftmals entweder fest ans Netz angeschlossen, mit einem Trenntransformator ausgerüstet oder an speziellen Steckdosen ohne Schutzschalter betrieben. Eine weitere Möglichkeit besteht darin, die Ableitströme - womöglich - auf den Nullleiter zu führen. Der Personenschutz wird über die Schutzleiter (PE) erreicht.

Die zuvor genannten Maßnahmen weisen jedoch wesentliche Nachteile auf.

Es werden kompakte und mobile Maschinen benötigt, die sich flexibel einsetzen lassen. Dazu gehört z. B., dass sich die Maschinen zur Reinigung aus den Produktionsräumen leicht an einen anderen Ort bringen lassen. Das ist mit fest angeschlossenen Maschinen nicht möglich.

Maschinen mit eingebautem Trenntransformator werden größer und schwerer, was die Beweglichkeit ebenfalls behindert - genau wie Trenntransformatoren, die in externe Gehäuse montiert sind, und der Maschine vorgeschaltet werden können. Durch die Trenntransformationen bleiben die Ableitströme und somit auch der Isolationsfehlerstrom auf der Sekundärseite des Trafos. Die Erkennung, ob ein Ausgleichsstrom fließt, kann aber vom Fehlerstromschutzschalter nur auf der Primärseite des Trafos gemessen und erkannt werden. Somit ist kein Schutz durch den Fehlerstromschutzschalter gewährleistet. Besonders in Feuchträumen ist dieser Schutz aber dringend erwünscht. Auch die Anbringung und Kennzeichnung von speziellen Steckdosen, die nicht mit Fehlerstromschutzschaltern abgesichert sind, erhöhen den Aufwand und reduziert die Flexibilität und auch die Sicherheit.

Sollen die Filterströme über den Nullleiter abgeleitet werden, sind spezielle Filter und Umrichter nötig. Die Ableitströme der Kabelschirme fließen nach wie vor über den Schutzleiter ab, weil die Schirme mit dem Nullleiter verbunden werden können. Ein getrennter Nullleiter ist nicht bei allen Netzformen vorhanden und damit ist diese Lösung nicht weltweit ersetzbar. Des Weiteren können mit einer umfangreicheren EMV-Filterung (größere und überdimensionierte Filter) die Hochfrequenzenableitströme reduziert werden. So können etwa wirksamere EMV-Eingangsfilter in Kombination mit zusätzlichen Ausgangsfiltern eingesetzt werden, was allerdings mit höheren Kosten verbunden ist. Ein weiterer Nachteil dieser Maßnahme gegen Ableitströme ist das Platzproblem, das vor allem bei der Nachrüstung mit größeren und zusätzlichen Filtern auftritt.

Der Einsatz von Fehlerstromschutzschaltern mit hoher Auslöseschwelle ist ebenfalls denkbar, jedoch mit erheblichen Risiken verbunden, da durch die höheren Ableitströme Potenzialverschiebungen auftreten und die zulässige Berührungsspannung von maximal 50 VAC überschritten werden kann. Außerdem sind Schäden an den einzelnen Komponenten des Systems möglich.

Hiervon ausgehend liegt der vorliegenden Erfindung die Aufgabe zugrunde, verbesserte Maschinen bereitzustellen, die flexibel ersetzbar sind und gleichzeitig sicher betrieben werden können.

Erfindungsgemäß wird diese Aufgabe durch die Merkmale der unabhängigen Ansprüche gelöst.

Die Vorrichtung ist eine Maschine mit einem Laststromkreis, der einen Ableitstrom erzeugt. Die Vorrichtung weist einen Motor auf, um beispielsweise ein Förderwerk anzutreiben. Um die gesetzlichen Anforderungen an die elektromagnetische Verträglichkeit zu erreichen, sind Filtermaßnahmen gegen elektrische Störungen notwendig. Dabei weist die Vorrichtung insbesondere auch einen Frequenzumrichter auf. Durch diesen mindestens einen Filter und ein Kabel zum Motor können Ableitströme entstehen, die einen Fehlerstromschutzschalter auslösen könnten. Aus diesem Grunde ist gemäß der vorliegenden Erfindung ein Ableitstromkompensator vorgesehen mit einer Einrichtung zum Erfassen eines Ableitstroms sowie eine Einrichtung zum Erzeugen eines Kompensationsstroms, der dem Ableitstrom entgegen gerichtet ist und mit dem Ableitstrom überlagert wird, derart, dass der Ableitstrom reduziert, insbesondere im Wesentlichen eliminiert wird. Dabei wird der Ableitstrom zumindest so stark reduziert, dass er unterhalb der Schwelle zum Auslösen eines RCD-Schutzschalters ist. Vorzugsweise wird der Ableitstrom vollständig eliminiert.

Dies bringt den Vorteil mit sich, dass sich die Ströme ausgleichen und der Fehlerstromschutzschalter nicht mehr wegen erhöhten Ableitströmen auslöst. Lediglich Isolationsfehler oder gefährliche Körperströme können erkannt werden und führen zur Auslösung. Dabei sollte z. B. ein Frequenzbereich von 100 Hz bis 300 kHz abgedeckt werden. Der Frequenzbereich 50-60 Hz darf nicht kompensiert werden, damit der Personenschutz wirksam bleibt. Die Erfindung bringt den Vorteil mit sich, dass ein voller Personenschutz gewährleistet wird, und die Vorrichtung dennoch bewegt werden kann, da diese nicht fest installiert werden muss und kein großer schwerer Trenntransformator integriert werden muss. Dies bringt unter anderem auch eine bessere Hygiene durch eine vereinfachte Reinigung der Maschine mit sich und eine große Flexibilität im Hinblick auf die Zusammensetzung von einzelnen Maschinen. Der Ableitstromkompensator ist kostengünstig und kann auf einfache Art bestehende Maschinen nachgerüstet werden. Im Vergleich zu Trenntransformatoren ergibt sich eine hohe Energieeffizienz. Gemäß der vorliegenden Erfindung ist ein weiter Spannungsbereich abdeckbar, derart, dass die Vorrichtung weltweit ersetzbar ist. Isolationsfehler oder Geräteschluss werden mit vorgeschalteten Fehlerstromschutzschaltern ZU 100 % erkannt.

Der Kompensationsstrom kann in seiner Phase zum Ableitstrom um 180° verschoben sein und im Wesentlichen die gleiche Amplitude aufweisen. Somit kann der Ableitstrom komplett kompensiert werden. Da es ausreichend ist, wenn der Ableitstrom unterhalb der Schwelle zur Auslösung des RCD-Schutzschalters ist, kann der Ableitstrom z.B. ca. 40% der Schaltschwelle des RCD-Schutzschalters betragen. Wesentlich dabei ist, dass der Ableitstrom z. B. kleiner als die Auslöseschwelle ist. Die Einrichtung zum Erzeugen eines Kompensationsstroms weist vorteilhafterweise einen Verstärker auf, sowie ein Kondensatornetzwerk (als Filterkondensatoren), über das Kompensationsstrom einzelnen Phasen eines Mehrphasensystems, insbesondere mindestens einer der drei Phasen, vorzugsweise allen drei Phasen eines Dreiphasensystems zugeführt werden kann. Dabei kann beispielsweise der Strom in allen drei Phasen erfasst werden und durch Differenzbildung der Ableitstrom jeder Phase bestimmt werden und im Hinblick auf eine symmetrische Lastverteilung ein jeweiliger Kompensationsstrom auf die entsprechenden Phasen geleitet wird.

Vorteilhafterweise wird der vom Verstärker erzeugte Kompensationsstrom derart auf die drei Phasen aufgeteilt, dass in Summe der Ableitstrom kompensiert bzw. ausreichend reduziert wird.

Bevorzugterweise befindet sich der Ableitstromkompensator zwischen einem Fehlerstromschutzschalter (RCD) und dem EMV-Filter, d. h. dem EMV-Eingangsfilter. Somit können die durch den Filter erzeugten Ableitströme kompensiert werden, jedoch auch weitere im Laststromkreis durch parasitäre Kopplung erzeugte Ableitströme, insbesondere bedingt durch lange Motorleitungen und/oder einem Frequenzumrichter. Gemäß einem bevorzugten Ausführungsbeispiel ist der Ableitstromkompensator in einem der Vorrichtung vorgeschalteten Gerät eingebaut. Insbesondere weist die Vorrichtung einen Stecker auf, der über eine Steckdose, insbesondere Industriesteckdose, mit dem Ableitstromkompensator verbindbar ist. Die Vorrichtung umfasst also dann dieses Gerät, das wiederum mit einem Stecker, insbesondere Industriestecker, über eine Steckdose, insbesondere Industriesteckdose, mit dem Netz verbunden werden kann. Dies bringt den Vorteil mit sich, dass die Vorrichtungen flexibel an unterschiedlichen Stellen eingesteckt werden können und ein entsprechendes Gerät einfach nachgerüstet werden kann. Ein entsprechendes vorgeschaltetes Gerät könnte dann auch für verschiedene Vorrichtungen verwendet werden. Es ist aber auch möglich, dass die Vorrichtung fest über ein Kabel mit dem vorgeschalteten Gerät verbunden ist, und dann über einen Stecker mit einer Steckdose, insbesondere Industriesteckdose, verbindbar ist. Die Spannungsversorgung des Ableitstromkompensators, insbesondere des Verstärkers, kann über die Spannungsversorgung der Vorrichtung, d.h. über die Netzspannung erfolgen. Wenn beispielsweise der Ableitstromkompensator in dem vorgeschalteten Gerät eingebaut ist, kann es zu dem Problem kommen, dass beim Einstecken dieses Geräts in die Industriesteckdose der Fehlerstromschutzschalter ausgelöst wird. Das kommt daher, dass beim Stecken die Phasen nicht genau gleichzeitig kontaktiert werden und dann durch die Y-Kondensatoren asymmetrische Ladeströme auftreten, die den vorgeschalteten RCD auslösen lassen. Um dies zu verhindern, weist die Vorrichtung eine Verzögerungseinrichtung auf, die derart ausgebildet ist, dass der Kompensationsstrom zeitverzögert überlagert wird, d. h. insbesondere erst dann, wenn beim Einstecken der Vorrichtung ans Netz alle Phasen des Steckers kontaktiert sind. Das heißt, dass vorzugsweise das Kondensatornetzwerk erst dann zugeschaltet wird, wenn beim Einstecken der Vorrichtung alle Phasen des Steckers kontaktiert sind. Dabei kann die Verzögerungsschaltung beispielsweise als Schaltrelais, Halbleiterrelais, Zeitrelais oder als Software-Lösung ausgebildet sein, oder aber in Form einer mechanischen Lösung realisiert werden, indem die Stromversorgung für die Kompensationseinrichtung über Steckerkontakte in einem Stecker erfolgt, die beim Zusammenstecken weiter hinter liegen, als die Kontakte für die Stromversorgung der Vorrichtung, sodass die Kontakte der Kompensationseinrichtung erst dann Kontakt haben, nachdem die Leistungskontakte bereits Kontakt haben.

Es ist auch möglich, dass der Ableitstromkompensator in der Vorrichtung integriert ist und über eine separate Hilfsspannungsversorgung versorgt wird, so dass beim Einschalten der Vorrichtung der Ableitstromkompensator bereits mit Strom versorgt wird bevor im Laststromkreis ein Ableitstrom erzeugt wird. Es ist vorteilhaft und platzsparend, wenn der Ableitstromkompensator in der Maschine integriert ist. Somit ergibt sich kein zusätzlicher Platzbedarf außerhalb der Maschine, wenn der Ableitstromkompensator in der Maschine integriert ist, wäre es möglich, dass der Fehlerstromschutzschalter (RCD) ungewollt auslöst, wenn nach der dem Einschalten der Vorrichtung bereits Ableitströme auftreten, der Kompensator aber noch nicht betriebsbereit ist. Um das zu verhindern, wird der Ableitstromkompensator mit der separaten Hilfsspannung versorgt, die anliegt, bevor der Laststromkreis den Ableitstrom erzeugt. Somit kann das System den Strom ausgleichen, bevor der Fehlerstromschutzschalter auslöst. Bei dieser Lösung ist es auch nicht mehr schädlich, wenn die Phasen der Laststromkreise unsymmetrisch zugeschaltet werden. Somit ist kein teurer Schutz mit gleichzeitig schließenden Kontakten erforderlich.

Wie bereits zuvor beschrieben, ermöglicht die vorliegende Erfindung, dass die Vorrichtung aussteckbar und somit bewegbar ist. Umfasst die Vorrichtung das externe Gerät mit dem Ableitstromkompensator weist dieses Gerät einen Netzstecker auf.

Bei dem erfindungsgemäßen Verfahren, insbesondere mit einer Vorrichtung nach mindestens einem der auf eine entsprechende Vorrichtung gerichteten Ansprüche wird beim Betrieb der Vorrichtung ein Ableitstrom, der den Laststromkreis erzeugt wird, erfasst und über einen Ableitstromkompensator ein Kompensationsstrom, der dem Ableitstrom entgegen gerichtet ist, erzeugt. Der Kompensationsstrom wird dem Ableitstrom überlagert, wodurch der Ableitstrom reduziert, insbesondere im Wesentlichen eliminiert wird.

Der Ableitstromkompensator umfasst einen Verstärker und ein Kondensatornetzwerk. Beim Einstecken der Vorrichtung wird vorteilhafterweise der Kompensationsstrom über das Kondensatornetzwerk erst dann zeitverzögert zugeschaltet, wenn beim Einstecken alle Phasen eines Steckers der Vorrichtung kontaktiert sind, d. h., am Netz angeschlossen sind.

Es ist auch möglich, dass die Spannungsversorgung des Ableitstromkompensators über die Spannungsversorgung der Vorrichtung erfolgt, oder aber, dass der Ableitstromkompensator in der Vorrichtung integriert ist und über eine separate Hilfsspannungsversorgung versorgt wird, derart, dass der Kompensationsstrom bereits anliegt, bevor ein Ableitstrom am Laststromkreis erzeugt wird. Somit kann das System den Strom ausgleichen, bevor der Fehlerstromschutzschalter auslöst.

Gemäß der vorliegenden Erfindung kann also nun die Vorrichtung ausgesteckt, d. h Netz über einen Netzstecker getrennt werden, an einen anderen Produktionsort bewegt werden und schließlich neu eingesteckt werden. Dies ermöglicht eine erhöhte Flexibilität bei gleichzeitiger Sicherheit.

Vorteilhafterweise befindet sich der Ableitstromkompensator zwischen einem Fehlerstromschutzschalter und einem EMV-Filter. Wenn der Ableitstromkompensator noch vor dem EMV-Eingangsfilter angeordnet ist, können die gesamten Ableitströme des Laststromkreises kompensiert werden. Es ist besonders vorteilhaft, wenn die Vorrichtung über ein dreiphasiges Netz mit Spannung versorgt wird und der Strom in den drei Phasen erfasst und durch Differenzbildung der Ableitstrom bestimmt wird, entsprechende Signale einem Verstärker zugeleitet werden, der eine Auswerteeinheit umfasst, um einen Kompensationsstrom zu erzeugen, der über ein Kondensatornetzwerk in mindestens eine, vorzugsweise alle drei Phasen eingespeist wird, wodurch es im Wesentlichen zu einer Eliminierung des Ableitstroms kommt.
- Fig. 1: zeigt grob schematisch eine erfindungsgemäße Vorrichtung mit Ableitstromkompensator.
- Fig. 2: zeigt grob schematisch ein Ersatzschaltbild eines Ableitstromkompensators.
- Fig. 3: zeigt grob schematisch eine Ausführungsform einer erfindungsgemäßen Vorrichtung mit externem Ableitstromkompensator.

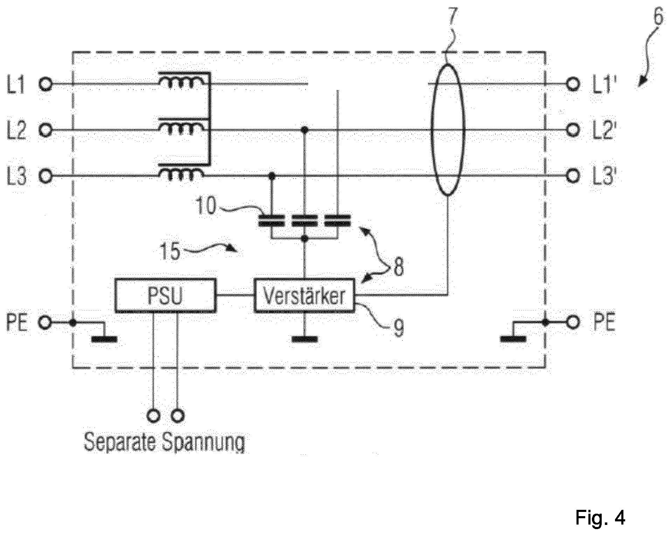

- Fig. 4: zeigt grob schematisch ein Ersatzschaltbild eines Ableitstromkompensators mit externer Spannungsversorgung.
- Fig. 5: zeigt grob schematisch ein weiteres Ausführungsbeispiel der vorliegenden Erfindung mit integriertem Ableitstromkompensator.
- Fig. 6: zeigt ein weiteres Ausführungsbeispiel gemäß der vorliegenden Erfindung.

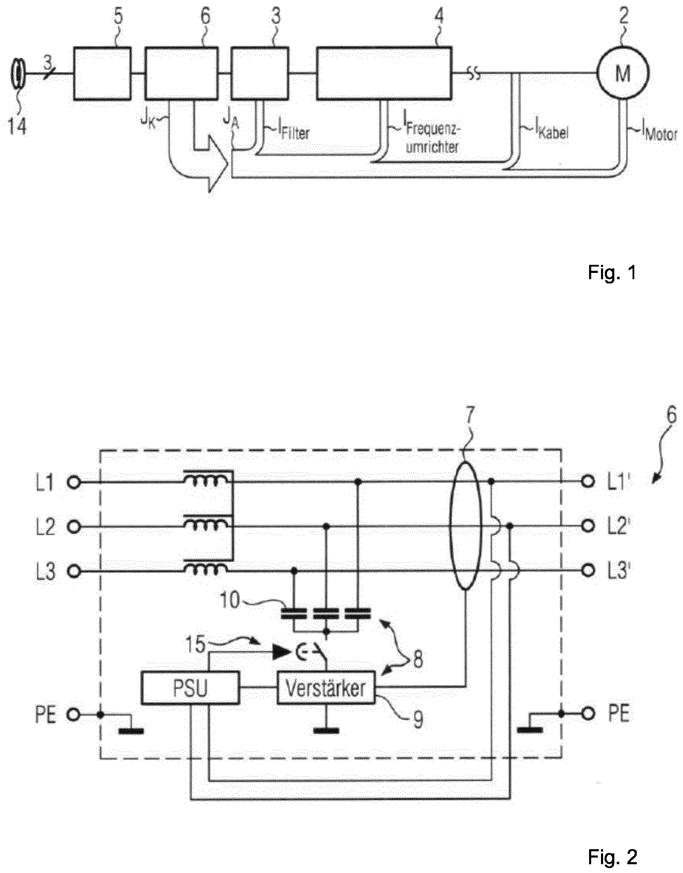

Fig. 1 zeigt grob schematisch einen Laststromkreis für den Motor 2. Fig. 1 zeigt grob schematisch ein typisches Antriebsystem, das im Wesentlichen einen EMV-Eingangsfilter 3, einen Frequenzumrichter 4, ein Motorkabel 5 und einen Motor 2 umfasst. Sowohl der EMV-Filter, als auch der Frequenzumrichter 4 und das lange Motorkabel sowie der Motor 2 können Ableitströme erzeugen, die einen Fehlerstromschutzschalter 5 auslösen würden. Gemäß der vorliegenden Erfindung ist ein Ableitstromkompensator 6 vor dem EMV-Filter 3 vorgesehen, der einen Kompensationsstrom I_{K} erzeugt, der dem Ableitstrom I_{A} entgegen gerichtet ist. Somit kann der Ableitstrom kompensiert, d. h. eliminiert, werden, aber zumindest soweit reduziert werden, dass er unterhalb der Schwelle zum Auslösen des RCD-Fehlerstromschutzschalters 5 liegt, beispielsweise unterhalb der Auslöseschwelle von 30 mA für Ströme im Frequenzbereich <100 Hz, bis 300 mA für Ströme mit einer Frequenz >1.000 Hz.

Der Ableitstrom I_{A} ist die Summe aller Einzelableitströme hier, die Summe aus I_{Filter} + I_{Frequenzumrichter} + I_{Kabel} + I_{Motor}. Gemäß der vorliegenden Erfindung soll ein Frequenzbereich zwischen 100 Hz und 300 kHz abgedeckt werden. Der Frequenzbereich von 50 bis 60 Hz darf nicht kompensiert werden, damit der Personenschutz wirksam bleibt. In der Praxis sind Kompensationsströme bis 1 A erforderlich. Der Kompensationsstrom I_{K} ist vorzugsweise in seiner Phase um 180° zum Ableitstrom I_{A} verschoben und weist im Wesentlichen die gleiche Amplitude auf

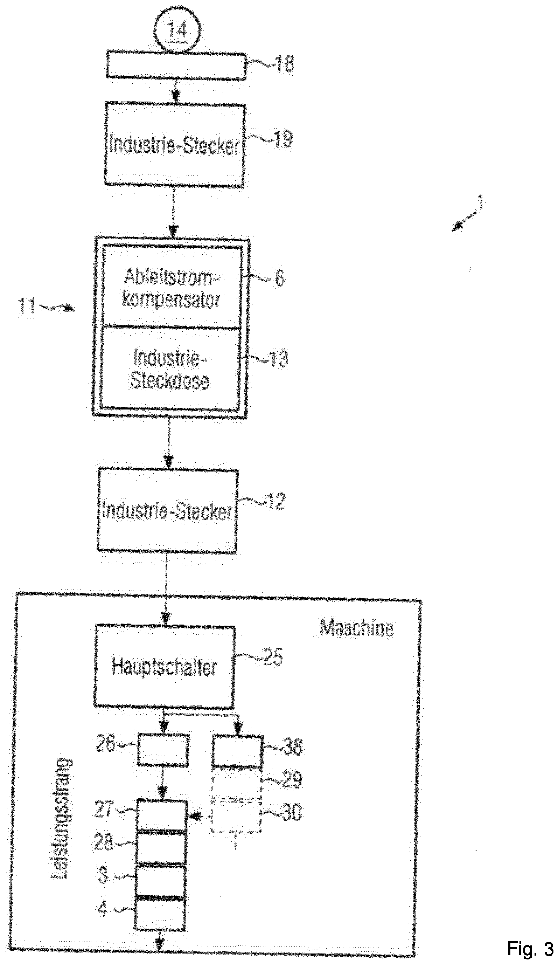

Fig. 2 zeigt ein Ersatzschaltbild des Ableitstromkompensators 6 für das in Fig. 3 gezeigte Ausführungsbeispiel. Fig. 2 zeigt ein Dreiphasennetz. Der Ableitstromkompensator 6 umfasst eine Einrichtung zum Messen eines Ableitstroms 7, sowie eine Einrichtung zum Erzeugen eines Kompensationsstroms 8. Die Einrichtung zum Erzeugen eines Kompensationsstroms 8 umfasst einen Verstärker 9, der mit der Einrichtung zum Messen des Ableitstroms 7 verbunden ist und eine Auswerteeinheit umfasst, die auf der Grundlage der Messwerte einen Ableitstrom I_{A} und einen Kompensationsstrom I_{K} bestimmen kann. Dabei kann beispielsweise die Einrichtung zum Erfassen eines Ableitstroms 7 eine Messzange umfassen. Es können die Ströme der drei Phasen erfasst werden und aus den entsprechenden Differenzen der Ableitstrom. Das bedeutet, wenn die Summe der Ströme in den drei Phasen L1, L2, L3 nicht 0 ist, dass es einen Ableitstrom U gibt. Der Kompensationsstrom I_{K} wird z.B. derart berechnet, dass er in seiner Phase um 180° zum Ableitstrom I_{A} verschoben ist und im Wesentlichen die gleiche Amplitude wie der Ableitstrom aufweist. Fig. 2 zeigt in vereinfachter Darstellung, dass der Verstärker 9 auf der Grundlage des ermittelten Kompensationsstroms I_{K} den Kompensationsstrom auf die drei Phasen einspeist, derart, dass die Summe der Ströme der einzelnen Phasen L1, L2, L3 z.B. wieder 0 ergibt und somit der Ableitstrom kompensiert wird, zumindest jedoch unter einer Auslöseschwelle des RCD-Schalters liegt.

Dabei kann beispielsweise der jeweilige Strom I_{L1}, I_{L2}, I_{L3} gemessen werden.

Durch Differenzbildung kann dabei z.B. ein Ableitstrom und ein entgegengesetzter Kompensationsstrom ermittelt werden, der dann auf die drei Phasen L1, L2, L3 aufgeteilt wird.

Es ist aber auch möglich, für jede Phase einen eigenen Ableitstrom zu bestimmen durch Messung der Ströme in jeder einzelnen Phase und dann entsprechende Kompensationsströme für die einzelnen Phasen zu ermitteln und jeder Phase entsprechend zuzuführen.

Bei diesem Ausführungsbeispiel wird der Ableitstromkompensator, wie auch bereits erläutert, über die Spannungsversorgung 14, hier über zwei der Phasen des Dreiphasensystems mit Spannung versorgt.

Die Vorrichtung umfasst vorteilhafterweise eine Verzögerungseinrichtung 15. Die Verzögerungseinrichtung 15 ist derart ausgebildet, dass der Kompensationsstrom I_{K} zeitverzögert, insbesondere erst, wenn beim Einstecken der Vorrichtung alle Phasen des Steckers 19 kontaktiert sind, überlagert wird. Das heißt, dass das Kondensatornetzwerk 10 erst dann zugeschaltet wird, wenn beim Einstecken der Vorrichtung alle Phasen des Steckers kontaktiert sind. Somit kann verhindert werden, dass bereits beim Einstecken der Vorrichtung 1 der RCD auslösen kann. Das Problem rührt daher, dass beim Einstecken die Phasen L1, L2, L3 nicht genau gleichzeitig kontaktiert werden und dann durch die Y-Kondensatoren des Kondensatornetzwerkes 10 asymmetrische Ladeströme auftreten, die den vorgeschalteten RCD 5 auslösen können. Durch die Verzögerungsschaltung 15 kann dies verhindert werden. Die Verzögerungsschaltung 15 kann beispielsweise als Zeitrelais, Halbleiterrelais, Zeitrelais, oder aber als Software-Lösung realisiert werden. Weiter besteht auch die Möglichkeit einer mechanischen Verzögerungseinrichtung 15, derart, dass der Ableitstromkompensator 6 zeitverzögert mit Spannung versorgt wird, indem beispielsweise der Stecker 19 derart ausgebildet ist, dass die Kontakte, die den Ableitstromkompensator 6 mit Spannung versorgen, beim Zusammenstecken weiter hinten sitzen, sodass sie erst Kontakt haben, nachdem die Leistungskontakte bereits Kontakt haben. Dies kann beispielsweise durch kürzere Pins realisiert werden.

Fig. 3 zeigt eine Ausführungsform gemäß der vorliegenden Erfindung mit einem externen Ableitstromkompensator 6, der außerhalb des Maschinengehäuses angeordnet ist. Fig. 3 zeigt eine Spannungsversorgung 14, beispielsweise ein dreiphasiges Netz, sowie eine Industriesteckdose 18, über die eine Vorrichtung mit einem Netzstecker 19 angesteckt werden kann. Bei diesem Ausführungsbeispiel ist der Ableitstromkompensator 6 in ein vorgeschaltetes Gerät 11 eingebaut, das eine weitere Industriesteckdose 13 aufweist, in die wiederum ein Industriestecker 12 der Vorrichtung 1 eingesteckt werden kann. Der Industriestecker 12 ist über eine entsprechende Leitung mit dem Hauptschalter 25 der Vorrichtung verbunden. Im Anschluss kann ein Motorschutzschalter 26 vorgesehen sein, sowie ein Hauptschütz 27 ohne "symmetrischen Kontakte, d. h. ohne Sprungkontakte. In Folge kann ein Netzdrosselteil 28 vorgesehen sein, gefolgt von einem EMV-Filter 3 und einem Frequenzumrichter von dem aus der Motor 2 versorgt werden kann. Nach dem Hauptschalter 25 kann eine Leitung zu einem Trafoschutzschalter 38 abzweigen, der mit einem Steuertrafo 29 verbunden ist und eine Steuerung 30 versorgt. Die Steuerung 30 ist mit dem Hauptschütz verbunden, um den Hauptschütz einzuschalten. Wie aus Fig. 3 hervorgeht, wird der Ableitstromkompensator 6 im gleichen Laststromkreis wie der Motor über die Spannungsversorgung 14 d.h. die Netzspannung mit Strom versorgt. Der Ableitstromkompensator befindet sich also vor dem Hauptschalter 25.

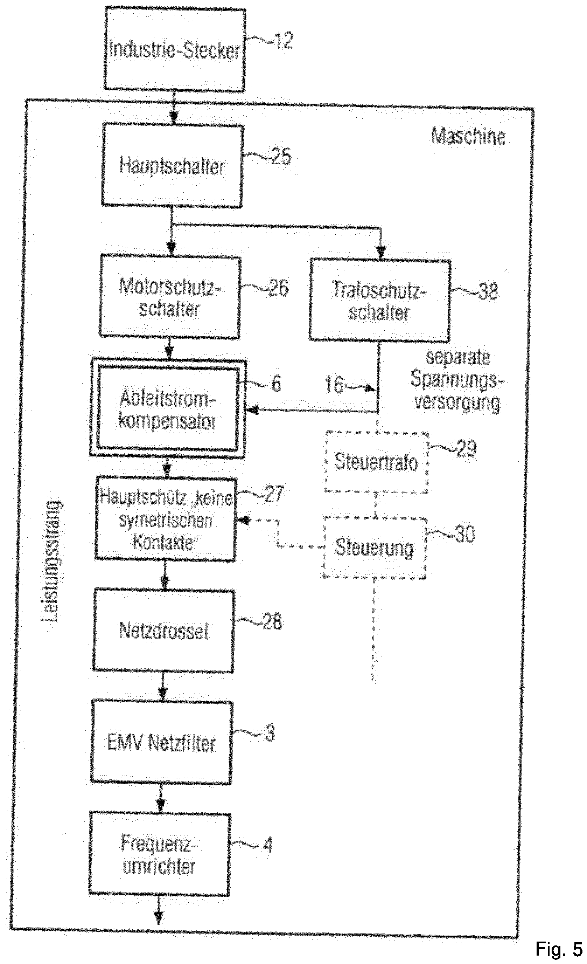

Fig. 5 zeigt eine weitere Ausführungsform gemäß der vorliegenden Erfindung. Hier wird der Ableitstromkompensator 6 direkt in die Vorrichtung eingebaut, d. h. integriert. Wie zu erkennen ist, befindet sich der Ableitstromkompensator 6 zwischen Industriestecker 12 und EMV Netzfilter 3. Um auch hierzu verhindern, dass der RCD-Fehlerstromschutzschalter ungewollt auslöst, wird der Ableitstromkompensator 6 mit einer separaten Hilfsspannung 16 versorgt und nicht wie beim ersten Ausführungsbeispiel über die Netzspannung 14. Hier können unterschiedliche separate Hilfsspannungsversorgungen 16 verwendet werden. Bei dem in Fig. 5 gezeigten Ausführungsbeispiel wird z. B. nach dem Hauptschalter Strom zu einem Trafoschutzschalter abgezweigt und dem Ableitstromkompensator 6 zugeführt. Dies verhindert das Problem, dass der RCD ungewollt auslöst, wenn nach dem Einschalten der Maschine bereits Ableitströme auftreten, der Kompensator aber noch nicht betriebsbereit ist. Um das zu verhindern, wird der Kompensator mit einer separaten Hilfsspannung versorgt, die anliegt, bevor die Laststromkreise, die Ableitstrom erzeugen, zugeschaltet werden. Somit kann das System den Ableitstrom I_{A} ausgleichen, bevor der RCD-Fehlerstromschutzschalter auslöst. Bei dieser Lösung ist es auch nicht mehr schädlich, wenn die Phasen der Laststromkreise unsymmetrisch zugeschaltet werden.

Somit ist kein teurer Schutz mit gleichzeitig schließenden Kontakten erforderlich.

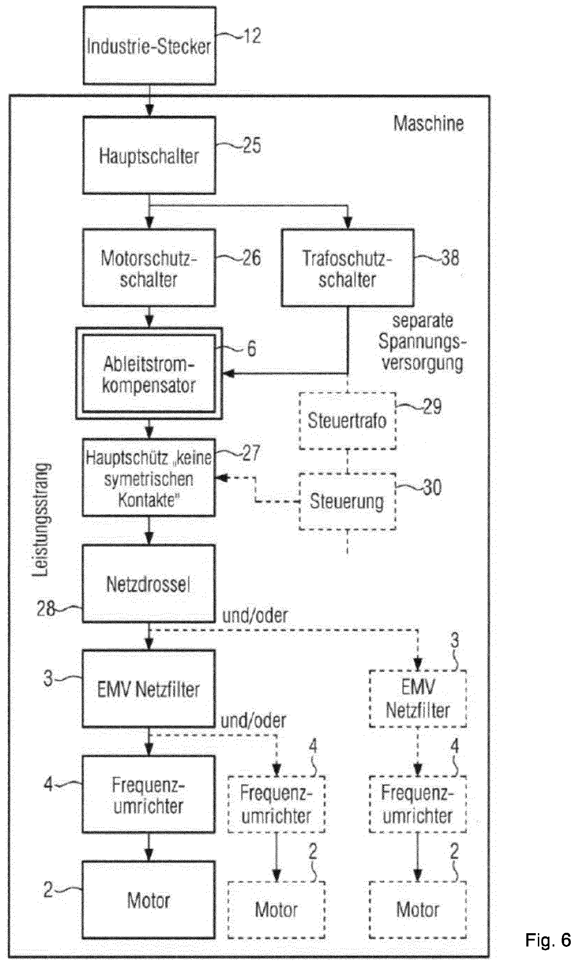

Figur 6 zeigt ein weiteres Ausführungsbeispiel gemäß der vorliegenden Erfindung. Dabei entspricht das in Figur 6 gezeigte Ausführungsbeispiel dem in Figur 5 gezeigten Ausführungsbeispiel. Bei diesem Ausführungsbeispiel gibt es in der Vorrichtung mehrere Motoren.

Das heißt, es sind in einer Maschine bzw. Anlage zusätzlich zu einem Motor noch ein oder mehrere Motoren für eine andere Funktionseinheit vorgesehen. Dabei kann beispielsweise gemäß einer ersten Alternative nach dem EMV-Netzfilter ein weiterer Frequenzumrichter für den weiteren Motor 2 vorgesehen sein und/oder nach der Netzdrossel ein weiterer EMV-Netzfilter und ein weiterer Frequenzumrichter für einen weiteren Motor vorgesehen sein. Somit können auch diese Laststromkreise, d.h. mehrere Motoren über nur einen Ableitstromkompensator 6 abgesichert werden.

### Bezugszeichenliste

- 1: Vorrichtung
- 2: Motor
- 3: EMV-Filter
- 4: Frequenzumrichter
- 5: RCD-Schutzschalter
- 6: Ableitstromkompensator
- 7: Einrichtung zum Messen eines Ableitstrom
- 8: Einrichtung zum Erzeugen eines Kompensationsstroms
- 9: Verstärker
- 10: Kondensatornetzwerk
- 11: vorgeschaltetes Gerät
- 12: Stecker
- 13: Steckdose
- 14: Spannungsversorgung
- 15: Verzögerungseinrichtung
- 16: separate Spannungsversorgung

## Patentansprüche

1. Mobile Vorrichtung (1) mit verringertem Ableitstrom, umfassend
- einem EMV-Filter (3),
- einem Frequenzumrichter (4),
- einem Motorkabel und einem Motor (2),
- einem Ableitstromkompensator (6) mit
• einer Einrichtung zum Erfassen des Ableitstroms (7),
• einer Einrichtung zum Erzeugen (8) eines Kompensationsstroms, der dem Ableitstrom entgegen gerichtet ist und mit dem Ableitstrom überlagert wird derart, dass der Ableitstrom reduziert wird.

2. Vorrichtung nach Anspruch 1, wobei der Kompensationsstrom in seiner Phase zum Ableitstrom um 180° verschoben ist und im Wesentlichen die gleiche Amplitude aufweist.

3. Vorrichtung nach Anspruch 1 oder 2, wobei die Einrichtung zum Erzeugen eines Kompensationsstroms (8) einen Verstärker (9) sowie ein Kondensatometzwerk (10) umfasst, über das der Kompensationsstrom einzelnen Phasen eines Mehrphasensystems mindestens einer der drei Phasen eines Dreiphasensystems zugeführt werden kann.

4. Vorrichtung nach mindestens einem der Ansprüche 1-3, wobei der Ableitstromkompensator (6) zwischen einem Fehlerstromschutzschalter (5) und dem EMV-Filter (3) angeordnet ist.

5. Vorrichtung nach mindestens einem der Ansprüche 1-4, wobei der Ableitstromkompensator (6) in einem der Vorrichtung vorgeschalteten Gerät (11) eingebaut ist und die Vorrichtung einen Stecker (12) aufweist, der über eine Steckdose (13) mit dem Ableitstromkompensator (6) verbindbar ist.

6. Vorrichtung nach Anspruch 5, wobei die Spannungsversorgung des Ableitstromkompensators (6) über die Spannungsversorgung (14) der Vorrichtung erfolgt.

7. Vorrichtung nach den Ansprüchen 3 und 6, wobei die Vorrichtung eine Verzögerungseinrichtung (15) aufweist, die derart ausgebildet ist, dass der Kompensationsstrom zeitverzögert überlagert wird und derart ausgebildet ist, dass das Kondensatornetzwerk (10) erst dann zugeschaltet wird, wenn beim Einstecken der Vorrichtung alle Phasen des Steckers (12) kontaktiert sind.

8. Vorrichtung nach mindestens einem der vorhergehenden Ansprüche, wobei der Ableitstromkompensator (6) in der Vorrichtung integriert ist und über eine separate Hilfsspannungsversorgung (16) versorgt wird.

9. Vorrichtung nach mindestens einem der Ansprüche 1-8, wobei die Vorrichtung aussteckbar ist.

10. Verfahren zur Produktion mit einer Vorrichtung nach mindestens einem der Ansprüche 1 - 9, wobei
beim Betrieb der Vorrichtung einen Ableitstrom erfasst wird und über einen Ableitstromkompensator (6) ein Kompensationsstrom, der dem Ableitstrom entgegen gerichtet ist erzeugt und dem Ableitstrom überlagert wird, wodurch der Ableitstrom reduziert wird.

11. Verfahren nach Anspruch 10, wobei der Ableitstromkompensator (6) einen Verstärker (9) sowie ein Kondensatornetzwerk (10) umfasst, und beim Einstecken der Vorrichtung der Kompensationsstrom über das Kondensatornetzwerk (10) erst dann zeitverzögert zugeschaltet wird, wenn beim Einstecken alle Phasen eines Steckers der Vorrichtung kontaktiert sind.

12. Verfahren nach Anspruch 10 oder 11, wobei die Spannungsversorgung (14) des Ableitstromkompensators (6) über die Spannungsversorgung (14) der Vorrichtung erfolgt oder aber dass der Ableitstromkompensator (6) in der Vorrichtung integriert ist und über eine separate Hilfsspannungsversorgung (16) versorgt wird.

13. Verfahren nach mindestens einem der Ansprüche 10-12, wobei die Vorrichtung ausgesteckt, an einen anderen Produktionsort bewegt und erneut eingesteckt wird.

14. Verfahren nach mindestens einem der Ansprüche 10-13, wobei der Ableitstromkompensator (6) zwischen einem Fehlerstromschutzschalter und einem EMV-Filter (3) angeordnet ist.

15. Verfahren nach mindestens einem der Ansprüche 10-14, wobei die Vorrichtung über ein dreiphasiges Netz mit Spannung versorgt wird und der Strom in den drei Phasen erfasst und entsprechende Signale einem Verstärker zugeleitet werden, der eine Auswerteeinheit umfasst um durch Differenzbildung den jeweiligen Ableitstrom zu bestimmen und einen Kompensationsstrom zu erzeugen, der über ein Kondensatornetzwerk in mindestens eine Phase eingespeist wird.
